# EUROPEAN PATENT APPLICATION

(11) **EP 2 339 642 A2**
(43) Date of publication of application: **29.06.2011**
(21) Application number: 10187593.8
(22) Date of filing: 14.10.2010
(51) Int. Cl.: H01L 31/0352, H01L 31/18, H01L 31/075

(54) **Solar cell and method of manufacturing the same**

(30) Priority: 01.12.2009 KR 20090118024
(71) Applicant: SAMSUNG ELECTRONICS CO., LTD., Suwon-si Gyeonggi-do 442-742 (KR)
(72) Inventor: Ko, Hwa-Young, Seoul (KR); Lee, Jin-Wook, Gyeonggi-do (KR); Lee, Doo-Youl, Seoul (KR)
(74) Representative: Greene, Simon Kenneth

(57) **Abstract**

A solar cell includes a semiconductor substrate, an n+ region and a p+ region disposed on the semiconductor substrate, a first electrode electrically connected to the n+ region, and a second electrode electrically connected to the p+ region. A trench formed in the semiconductor substrate separates the n+ region from the p+ region.

## Description

### BACKGROUND

### 1) Field

This general inventive concept relates to a solar cell and a method of manufacturing the same.

### 2) Description of the Related Art

A solar cell is a photoelectric conversion device that transforms solar energy into electrical energy. Solar cells have been attracting increased attention as an alternative, clean energy source.

A solar cell typically includes semiconductors, such as p-type and n-type semiconductors, and produces electrical energy by transferring electrons and holes to the n-type and p-type semiconductors, respectively, and collecting electrons and holes at electrodes when an electron-hole pair ("EHP") is produced by solar light energy absorbed in a photoactive layer inside the semiconductors.

Solar cells should be as efficient as possible when producing electrical energy from solar energy. To increase the efficiency of solar cells, it is desired to produce a maximum number of electron-hole pairs in the semiconductor, and withdraw the resultant charge with minimal loss.

Accordingly, various methods to improve generation efficiency of electron-hole pairs and reduce recombination of generated electrons and holes, resulting in improvement in efficiency of the solar cell, have been suggested. However, these various methods require lengthy additional processes in manufacturing the solar cells, thereby causing a significant increase in manufacturing costs thereof.

### SUMMARY

The general inventive concept includes a method of manufacturing a solar cell to improve an efficiency of the solar cell, and to reduce process times and manufacturing costs of the same.

Provided is a solar cell that includes a semiconductor substrate, an n+ region and a p+ region disposed on the semiconductor substrate, a first electrode electrically connected to the n+ region, and a second electrode electrically connected to the p+ region. A trench formed in the semiconductor substrate separates the n+ region from the p+ region.

The solar cell may include pluralities of n+ regions and p+ regions, and the n+ regions and the p+ regions may be alternately disposed on the semiconductor substrate. The n+ region may have a thickness from about 30 nanometers (nm) to about 200 nm.

The trench is disposed between the n+ region and the p+ region, the trench penetrates at least one of the n+ region and the p+ region, and the trench is formed by cutting a portion of the semiconductor substrate. The trench may have a depth from about 500 nm to about 50 micrometers (µm) and a width from about 10 nm to about 10 µm.

The solar cell may further include a dielectric layer disposed on the n+ region, and the dielectric layer may be disposed on a portion of the semiconductor substrate where the first electrode, the second electrode and the trench are not disposed. The dielectric layer may have a thickness from about 10 nm to about 500 nm.

In addition, the solar cell may further include a passivation layer disposed on the semiconductor substrate, and the passivation layer may be disposed on a portion of the semiconductor substrate where the first electrode and the second electrode are not disposed. The passivation layer may have a thickness from about 10 nm to about 500 nm.

Also provided is a method of manufacturing a solar cell that includes: providing a semiconductor substrate; disposing an n+ layer on the semiconductor substrate to form an n+ region on the semiconductor substrate; removing a portion of the n+ layer; forming a trench in the semiconductor substrate; disposing a first electrode on the semiconductor substrate; and disposing a second electrode on the semiconductor substrate. The first electrode and the second electrode are separated by the trench.

While forming the trench, a plurality of n+ regions may be formed.

The forming the trench may include using a laser, and may further include removing a portion of at least one of the semiconductor substrate, the n+ layer and a dielectric layer, which is damaged by the laser.

The method may further include disposing a plurality of first electrodes and a plurality of second electrodes, and the first electrodes and the second electrodes may be alternately disposed on the semiconductor substrate.

The method may further include disposing a dielectric layer on the n+ layer after the disposing the n+ layer.

In addition, the method may further include disposing a passivation layer on the semiconductor substrate after the forming the trench.

The method may further include converting a portion of the n+ layer, corresponding to the second electrode, into a p+ region after the forming the trench.

The first electrode and/or the second electrode may be formed by using a paste composition.

### BRIEF DESCRIPTION OF THE DRAWINGS

The above and other aspects of the present invention will become more readily apparent by describing in further detail example embodiments thereof with reference to the accompanying drawings, in which:
FIG. 1 is a partial cross-sectional view of an example embodiment of a solar cell according one embodiment; and
FIGS. 2A through 2G are partial cross-sectional views illustrating an example embodiment of a method of manufacturing a solar cell.

### DETAILED DESCRIPTION

The general inventive concept will now be described more fully hereinafter with reference to the accompanying drawings, in which various example embodiments are shown. The general inventive concept may, however, be embodied in many different forms, and should not be construed as limited to the example embodiments set forth herein. Rather, these example embodiments are provided so that this disclosure will be thorough and complete, and will fully convey the scope of the general inventive concept to those of ordinary skill in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular example embodiments only and is not intended to be limiting. As used herein, the singular forms "a," "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the figures. It will be understood that relative terms are intended to encompass different orientations of the device in addition to the orientation depicted in the figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Example embodiments are described herein with reference to cross section illustrations that are schematic illustrations of idealized example embodiments. As such, variations from the shapes of the illustrations as a result, for example, of manufacturing techniques and/or tolerances, are to be expected. Thus, example embodiments described herein should not be construed as limited to the particular shapes of regions as illustrated herein but are to include deviations in shapes that result, for example, from manufacturing. For example, a region illustrated or described as flat may, typically, have rough and/or nonlinear portions. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, example embodiments of the general inventive concept will be described in further detail with reference to the accompanying drawings

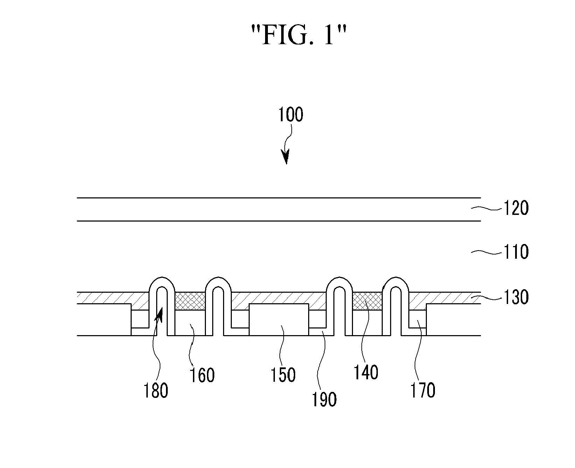

A solar cell according to an example embodiment will now be described in further detail with reference to FIG. 1.

FIG. 1 is a partial cross-sectional view of an example embodiment of a solar cell 100.

Hereinafter, a side of a semiconductor substrate 110 that receives solar energy will be referred to as a "front side," and another side, opposite to the front side of the semiconductor substrate 110, will be referred to as a "rear side," but it will be noted that the use of these terms should not be interpreted as limiting example embodiments. Specifically, for example, in another example embodiment, a "rear side" of the semiconductor substrate 110 may receive the solar energy. Moreover, for purposes of description, relationships relative to, or between, the front and lower sides, e.g., references to upper and lower positions, will be described as being from the center of the semiconductor substrate 110, but it will be noted that such description does not limit the example embodiments described herein.

Referring now to FIG. 1, the solar cell 100 according to an example embodiment includes the semiconductor substrate 110, a highly-doped n-type semiconductor region 130 (hereinafter referred to as an "n+ region 130") and a highly-doped p-type semiconductor region 140 (hereinafter referred to as a "p+ region 140") disposed on the semiconductor substrate 110 and separated by a trench 180, a first electrode 150 electrically connected to the n+ region 130 and a second electrode 160 electrically connected to the p+ region 140. In an example embodiment, the n+ region 130 the p+ region 140 are disposed on the rear (lower) side of the semiconductor substrate 110 (as viewed in FIG. 1), e.g., on the non-light-receiving side of the semiconductor substrate 110, but additional example embodiments are not limited thereto.

As shown in FIG. 1, the solar cell 100 may include a plurality of n+ regions 130 and a plurality of p+ regions 140, with the n+ regions and the p+ regions being alternately disposed on bottom side of the semiconductor substrate 110.

The trench 180 may be disposed, e.g., may be positioned, between the n+ regions 130 and the p+ regions 140, and the trench 180 may penetrate through the n+ region 130 and the p+ region 140. In an example embodiment, the trench 180 may be formed by cutting away a portion of the semiconductor substrate 110, as will be described in greater detail below.

The semiconductor substrate 110 may include, e.g., may be made of, crystalline silicon or a compound semiconductor. Examples of the crystalline silicon may include, but are not limited to, a silicon wafer. As shown in FIG. 1, the semiconductor substrate 110 is a semiconductor substrate doped with a p-type impurity, but the semiconductor substrate 110 may be a semiconductor substrate doped with an n-type impurity. The p-type impurity may include a Group III compound, such as boron (B) or aluminum (Al), for example, and the n-type impurity may be a Group V compound, such as phosphorus (P), for example.

When the semiconductor substrate 110 is a semiconductor substrate doped with the p-type impurity, the first electrode 150 may have a larger area on the semiconductor substrate 110 than an area of the second electrode 160 thereon. As a result, and since the semiconductor substrate 110 is doped with the p-type impurities, the semiconductor substrate 110 has a large amount of holes (relative to a semiconductor substrate doped with n-type impurities), and the semiconductor substrate 110 effectively collects electrons at the first electrode 150, and an efficiency of the solar cell 100 according to an example embodiment is thereby effectively maximized and/or significantly improved.

In another example embodiment (not shown), the semiconductor substrate 110 is doped with the n-type impurity, and the second electrode 160 may have a larger area on the semiconductor substrate 110 than the first electrode 150. As a result, the semiconductor substrate 110 has a large amount of electrons (relative to a semiconductor substrate doped with p-type impurities) and effectively collects holes at the second electrode 160, which effectively maximizes and/or significantly improves the efficiency of the solar cell 100.

In an example embodiment, the semiconductor substrate 110 may have a textured surface, e.g., a front (light-receiving) surface of the semiconductor substrate 110 may have protrusions and depressions, such as in a pyramid shape, or a porous structure such as a honeycomb structure, to substantially increase light absorption and significantly reduce reflectance, resulting in further increased efficiency of the solar cell 100. It will be noted, in that additional embodiments, the semiconductor substrate 110 may have surfaces with different textures than described above.

Referring still to FIG. 1, an anti-reflection coating 120 is disposed on the front (e.g., upper) surface of the semiconductor substrate 110, but in additional example embodiments, the anti-reflection coating 120 may be omitted. The anti-reflection coating 120 may include, e.g., may be made from, an insulating material having low light reflectance, and may, for example, include: oxides such as aluminum oxide (Al₂O₃), silicon oxide (SiO₂), titanium oxide (TiO₂ or TiO₄), magnesium oxide (MgO), cerium oxide (CeO₂) or any combinations thereof; nitrides such as aluminum nitride (AlN), silicon nitride (SiNₓ), titanium nitride (TiN) or any combinations thereof; and/or oxynitrides such as aluminum oxynitride (AlON), silicon oxynitride (SiON), titanium oxynitride (TiON) or any combinations thereof. The anti-reflection coating 120 may be formed as a single layer or, alternatively, may include a plurality of layers.

In an example embodiment, the anti-reflection coating 120 may have a thickness from about 5 nanometers (nm) to about 300 nm, and in one example embodiment, may have a thickness from about 50 nm to about 80 nm, although additional example embodiments are not limited thereto.

As shown in FIG. 1, the anti-reflection coating 120 is disposed on the front surface of the semiconductor substrate 110, and the anti-reflection coating 120 decreases the reflectance of light incident to the front surface of the solar cell 100 to increase the selectivity of light in a predetermined wavelength region. In addition, the efficiency of the solar cell 100 is further increased by improving contact characteristics of silicon included in the front surface of the semiconductor substrate 110 (such as with the anti-reflection coating 120, but not being limited thereto).

The n+ regions 130 and the p+ regions 140 are disposed on the rear surface of the semiconductor substrate 110 and are separated by trenches 180 formed by cutting out associated portions of the semiconductor substrate 110. The n+ regions 130 and the p+ regions 140 may be alternately disposed on the semiconductor substrate 110, as shown in FIG. 1.

In an example embodiment, the n+ region 130 may be highly doped with an n-type impurity, so that the n+ region 130 easily collects produced electrons at the electrode side, e.g., at the first electrode 150. The n+ region 130 may have a thickness from about 30 nm to about 200 nm. When the n+ region 130 has a thickness within the abovementioned range, direct contact between the first electrode 150 and the semiconductor substrate 110 is effectively prevented, thereby substantially reducing and/or effectively preventing charge leakage. As a result, the semiconductor substrate 110 effectively transmits the electrons produced therein to the first electrode 150, and prevents recombination of the electrons with holes to substantially improve the efficiency of the solar cell 100. In at least one example embodiment, the n+ region 130 may have a thickness from about 50 nm to about 100 nm, but additional example embodiments are not limited thereto.

In addition, since the p-type impurity is highly doped into the p+ region 140, e.g., is present at a high concentration in the p+ region 140, the p+ region 140 easily collects produced holes at the electrode side, e.g., at the second electrode 160. In an example embodiment, the p+ region 140 may be formed through an additional process (but is not limited thereto) and, more specifically, the p+ region 140 may be formed by permeating the p-type impurity included in a material used for forming the second electrode 160 on the semiconductor substrate 110 while forming the second electrode 160.

In an example embodiment, the first electrode 150 is disposed under the n+ region 130, on the semiconductor substrate 110, as shown in FIG. 1.

The first electrode 150 collects electrons produced in the semiconductor substrate 110 and transmits the electrons outside the solar cell 100, e.g., to an external device (not shown). The first electrode 150 may be formed of a low-resistance metal such as silver (Ag), for example, but is not limited thereto.

As also shown in FIG. 1, the second electrode 160 is disposed under the p+ region 140 on the semiconductor substrate 110. The second electrode 160 collects holes and may include, e.g., may be formed of, a metal such as aluminum (Al), for example, but is not limited thereto. When the second electrode 160 is formed of a paste including aluminum, for example, the aluminum acts as a p-type impurity to form the p+ region 140 upon contacting aluminum to the silicon of the semiconductor substrate 110. Accordingly, an additional process for forming the p+ region 140 may be omitted, thereby substantially improving a manufacturing efficiency of the solar cell 100 according to an example embodiment.

Still referring to FIG. 1, a dielectric layer 170 may be disposed on at least a portion of a surface of the n+ region 130 and, more particularly, may disposed on a portion of the n+ region 130 where the first electrode 150 and/or the second electrode 160, and the trench 180 are not provided. In another example embodiment, the dielectric layer 170 may be omitted. The dielectric layer 170 prevents current leakage, as well as recombination of charges, to thereby further increase the efficiency of the solar cell 100. In addition, the dielectric layer 170 may passivate the rear side of the semiconductor substrate 110.

The dielectric layer 170 may include a material selected from a group consisting of an oxide, a nitride, an oxynitride and any combinations thereof. Moreover, the oxide may include aluminum oxide (Al₂O₃), silicon oxide (SiO₂), titanium oxide (TiO₂ or TiO₄) or any combinations thereof, while the nitride may include aluminum nitride (AlN), silicon nitride (SiNₓ), titanium nitride (TiN) or any combinations thereof, and the oxynitride may include aluminum oxynitride (AlON), silicon oxynitride (SiON), titanium oxynitride (TiON) or any combination thereof.

The dielectric layer 170 may be formed as n a single layer or, in another example embodiment, as a plurality of layers, and may have a thickness from about 10 nm to about 500 nm. When the dielectric layer 170 has a thickness within the abovementioned range, the dielectric layer 170 passivates, e.g., reduces a chemical reactivity of, the rear surface of the semiconductor substrate 110 to increase a photoelectric current from back-reflecting light, having a long wavelength, into the semiconductor substrate 110, to provide excellent chemical resistance. In at least one example embodiment, the dielectric layer 170 may have a thickness from about 100 nm to about 200 nm.

As described above, the trench 180 penetrates the n+ region 130, the p+ region 140 and the dielectric layer 170, and is formed by cutting a portion of the semiconductor substrate 110, such as with a laser, for example.

Since the trench 180 physically separates the n+ region 130 from the p+ region 140 an additional complicated patterning process is not required, and an overlap margin is ensured, and a process of forming the first electrode 150 and the second electrode 160 is thereby improved and/or simplified. Additionally, electrical short circuits are effectively prevented.

In an example embodiment, the trench 180 may have a depth from about 500 nm to about 50 micrometers (µm). When the trench 180 has a depth within the abovementioned range, damage to a portion of the semiconductor substrate 110 is substantially reduced and/or is effectively prevented, and the n+ region 130 is easily separated from the p+ region 140. According to at least one example embodiment, the trench 180 may have a depth from about 1 µm to about 10 µm

The trench 180 may have a width from about 10 nm to about 10 µm, for example. When the trench 180 has a width within the abovementioned range, the process of forming the first electrode 150 and the second electrode 160 is efficiently performed, and an area of the first electrode 150 and the second electrode 160 may be improved (e.g., may be increased). In at least one example embodiment, the trench 180 may have a thickness from about 100 nm to about 8 µm, and the trench 180 may have a width from about 1 µm to about 5 µm, although additional example embodiments are not limited thereto. The depth and the width of the trench 180 may be controlled by adjusting process conditions for forming the trench 180, such as a laser intensity and/or a laser irradiation time, for example, when the trench 180 is formed using a laser.

The solar cell according to another example embodiment may further include a passivation layer 190 on the rear surface of the semiconductor substrate 110. More particularly, the passivation layer 190 may be disposed in a region where the first electrode 150 and the second electrode 160 are not provided on the rear surface of the semiconductor substrate 110. The passivation layer 190 may be disposed on, for example, the lower part of the dielectric layer 170 and/or the inside of the trench 180. However, the passivation layer 190 according to additional example embodiments is not limited to the foregoing description, and the passivation layer 190 may be provided only inside the trench 180, for example.

The passivation layer 190 protects the rear surface of the semiconductor substrate 110. In addition, the passivation layer 190 prevents recombination of charges, and also prevents current leakage, to further improve the efficiency of the solar cell 100.

The material for forming the passivation layer 190 may include the same material for forming the dielectric layer 170 and, in one example embodiment, the passivation layer 190 may be the dielectric layer 170 (best shown in FIG. 1).

The passivation layer 190 may be formed in a single layer or, alternatively, may include a plurality of layers, and the passivation layer 190 may have a thickness from about 10 nm to about 500 nm. When the passivation layer 190 has a thickness within the abovementioned range, it effectively passivates the rear surface of the semiconductor substrate 110 and effectively back-reflects light having the long wavelength into the semiconductor substrate 110, to increase a photoelectric current. Additionally, the electrode forming process is efficiently formed to produce electrodes as the passivation layer has excellent chemical resistance. According to at least one example embodiment, the passivation layer may have a thickness from about 100 nm to about 200 nm.

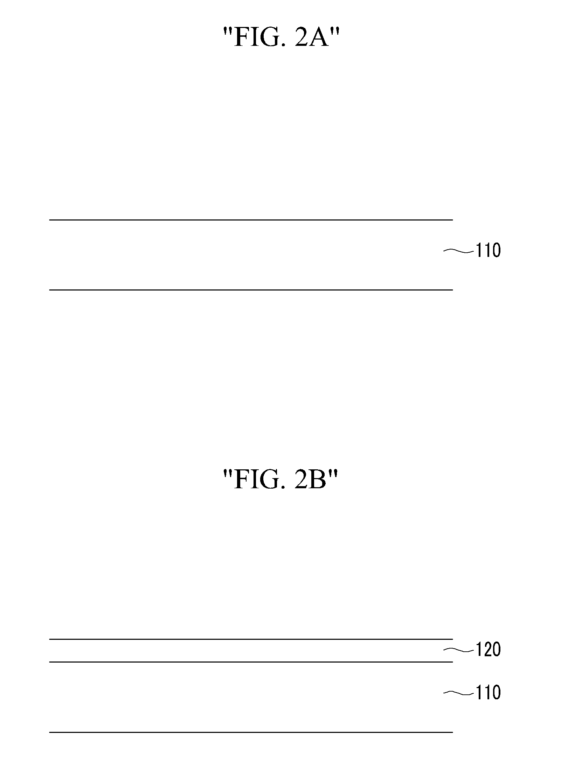

An example embodiment of a method of manufacturing a solar cell will now be described in further detail with reference to FIGS. 2A through 2G.

FIGS. 2A through 2G are partial cross-sectional views illustrating an example embodiment of a method, e.g., a process, of manufacturing a solar cell 100. The same or like components in FIG. 1, described in greater detail above, are labeled with the same reference character in FIGS. 2A-2G and, thus, any repetitive detailed description thereof will hereinafter be omitted or simplified.

Referring to FIG. 2A, a semiconductor substrate 110 is provided. Specifically, for example, a semiconductor substrate 110, such a silicon wafer, may be provided. The semiconductor substrate 110 may be doped with a p-type impurity or, alternatively, an n-type impurity, as described in greater detail above.

The semiconductor substrate 110 is subjected to a surface texturing treatment. The surface-texturing treatment may be performed by a wet method using a strong acid such as nitric acid and/or hydrofluoric acid, or using a strong base such as sodium hydroxide, or by a dry method using plasma, for example.

Referring to FIG. 2B, an anti-reflection coating 120 is disposed, e.g., is provided, on a front (e.g., upper) surface of the semiconductor substrate 110. It will be noted that the process of providing the anti-reflection coating 120 shown in FIG. 2B may be omitted in another example embodiment. The anti-reflection coating 120 may be formed from, for example, silicon nitride, by a process such as plasma enhanced chemical vapor deposition ("PECVD"), for example. However, additional example embodiments are not limited thereto, and the anti-reflection coating 120 may be formed with other materials and/or processes.

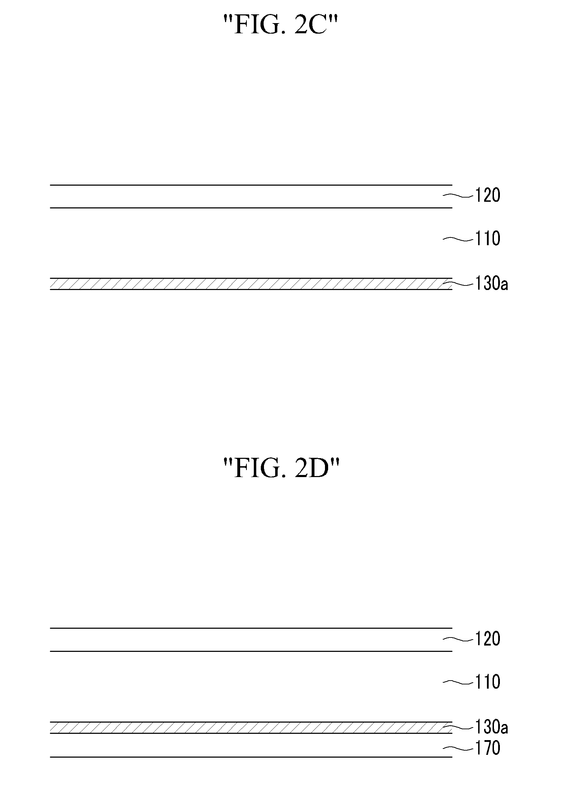

As shown in FIG. 2C, an n+ layer 130a is disposed on, e.g., is formed on, a rear (e.g., lower) surface of the semiconductor substrate 110. The n+ layer 130a may be formed by doping a Group V element, such as phosphorus (P), in the semiconductor substrate 110. The process of doping to form the n+ layer 130a may include vapor diffusion, solid-phase diffusion or ion implantation, for example, but is not limited thereto.

As shown in FIG. 2D, a dielectric layer 170 is disposed under the n+ layer 130a, although the process of providing the dielectric layer 170 may be omitted in one or more example embodiments. The dielectric layer 170 may be provided using PECVD with, for example, silicon nitride, but it is not limited thereto, as the dielectric layer 170 may be formed by other materials and/or methods.

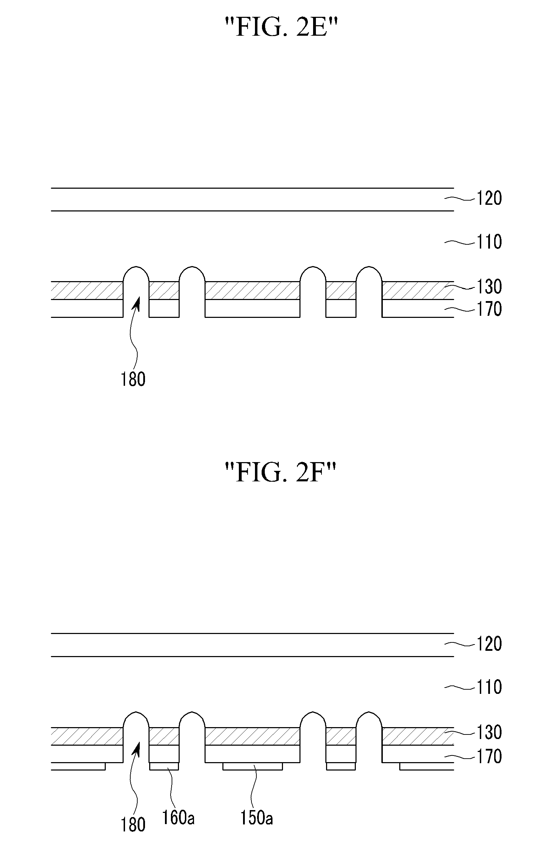

As shown in FIG. 2E, a trench 180 is formed in the rear surface of semiconductor substrate 110 by penetrating through the n+ layer 130a and the dielectric layer 170. In an example embodiment, the trench 180 is formed by cutting a portion of the semiconductor substrate 110. Thus, a plurality of n+ regions 130, each being separated from the others, is formed.

Still referring to FIG. 2E, the trench 180 may be formed by etching a portion of the rear surface of the semiconductor substrate 110, the n+ layer 130a, and the dielectric layer 170 with a laser, for example. The laser may include a yttrium aluminum garnet ("YAG") laser or a carbon dioxide (CO₂) laser, for example, but is not limited thereto. In addition, the depth and the width of the trench 180 may be controlled by adjusting conditions such as the laser intensity and/or the laser irradiation time, for example.

The forming of the trench 180 may further include removing a portion of the semiconductor substrate 110, the n+ layer 130a and/or the dielectric layer 170 that is damaged by the laser after etching the portion of the rear surface of the semiconductor substrate 110, the n+ layer 130a and/or the dielectric layer 170. The removing of the portion that is damaged by the laser may include a wet etching process, such as a process using KOH, a process using NaOH and Radio Corporation of America ("RCA") cleaning, or using a dry etching process using Cl₂ gas or a fluorine-based gas, such as SF₆, CF₄, C₂F₆, C₃F₆, C₄F₈ or NF₃, for example, but is not limited thereto.

It will be noted that the forming the trench 180 is not limited to the foregoing description, and that the trench 180 may be formed by other materials and/or methods.

A passivation layer (not shown) may be disposed under the semiconductor substrate 110 after providing the trench 180. According to at least one example embodiment, the passivation layer may be formed under the dielectric layer 170 and inside the trench 180. The passivation layer may be formed using PECVD with, for example, silicon nitride, but is not limited thereto, and the passivation layer may be formed with other materials and/or methods.

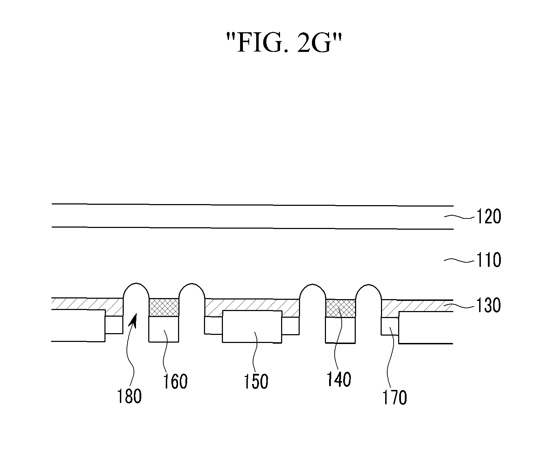

As shown in FIG. 2F, a conductive paste 150a for a first electrode 150 (FIG. 2G) and a conductive paste 160a for a second electrode 160 (FIG. 2G) are disposed under the dielectric layer 170 and are separated by the trench 180. The conductive paste 150a for a first electrode 150 and the conductive paste 160a for a second electrode 160 may be alternately formed on the semiconductor substrate 110, as shown in FIG. 2F.

The conductive paste 150a for the first electrode 150 and the conductive paste 160a for the second electrode 160 may be formed using a screen printing method, for example. The screen printing method may include coating a conductive paste for an electrode including metal powder such as silver (Ag) and/or aluminum (A1), for example, on a position where the associated electrode is to be provided, and drying the conductive paste. However, it will be noted that additional example embodiments are not limited thereto, and the electrodes may be formed by inkjet printing or press printing, for example.

As shown in FIG. 2G, the first electrode 150 is thereby formed, and is electrically connected to the n+ region 130, while the second electrode 160, including the p+ region 140, is formed on the rear surface of the semiconductor substrate 110. As shown in FIG. 2G, the p+ region 140 directly contacts the rear surface of the semiconductor substrate 110, but additional example embodiments are not limited thereto.

The conductive paste 150a for the first electrode 150 and the conductive paste 160a for the second electrode 160 are baked, and the metal powder included in the conductive paste 150a for the first electrode 150 permeates into the n+ region 130 of the semiconductor substrate 110 to form the first electrode 150, and the metal powder, such as the aluminum (A1) powder, included in the conductive paste 160a for the second electrode 160 permeates into the semiconductor substrate 110 to form the second electrode 160 including the p+ region 140. In an example embodiment, the baking may be performed at a temperature that is greater than the fusion temperature of the metal powder, such as at a temperature from about 500 degrees Celsius (°C) to about 1000 °C, for example.

Thus, FIGS. 2F and 2G show an example embodiment of a process of forming the electrodes using the paste composition for an electrode, but it will be noted that additional example embodiments are not limited thereto, and the electrodes may be formed by various other methods and/or materials. Specifically, for example, the second electrode 160 may be formed by doping a p-type impurity onto a portion of the n+ region 130 where the second electrode 160 is to be provided and shifting, e.g., converting, the portion into the p+ region 140, or by etching the portion of the n+ region 130 where the second electrode 160 is to be provided and providing the p+ region 140, and providing the second electrode 160 under the p+ region 140.

As described above, the solar cell 100 according to the example embodiments described herein separates the first electrode 150 and the second electrode 160 by providing the trench 180 for separating the n+ region 130 from the p+ region 140. As a result, electrical short circuits are effectively prevented, and electrons and holes are efficiently collected at the electrodes. Accordingly, efficiency of the solar cell 100 is significantly improved.

In addition, in the method of manufacturing the solar cell 100 according to other example embodiments, the method includes providing the n+ layer 130a on a surface of the semiconductor substrate 110, etching the same with a laser to form a plurality ofn+ regions 130, and forming a first electrode 150 and a second electrode 160 separated from each other by a trench 180 formed therebetween in the semiconductor substrate 110. As a result, the solar cell 100 is manufactured by a substantially simplified process. Thus, the process time of manufacturing the solar cell 100 is significantly reduced, and process costs thereof are greatly reduced.

While the general inventive concept has been particularly shown and described with reference to example embodiments thereof, it will be understood by those of ordinary skill in the art that various changes in form and details may be made therein without departing from the scope of the present invention as defined by the following claims.

## Claims

1. A solar cell comprising:
a semiconductor substrate (110);
an n+ region (130) disposed on the semiconductor substrate;
a p+ region (140) disposed on the semiconductor substrate;
a first electrode (150) electrically connected to the n+ region; and
a second electrode (160) electrically connected to the p+ region,
wherein a trench (180) formed in the semiconductor substrate separates the n+ region from the p+ region.

2. The solar cell of claim 1, further comprising pluralities of n+ regions (130) and p+ regions (140), wherein the n+ regions and the p+ regions are alternately disposed on the semiconductor substrate.

3. The solar cell of claim 1 or 2, wherein the n+ region (130) has a thickness from about 30 nanometers to about 200 nanometers.

4. The solar cell of any preceding claim, wherein
the trench (180) is disposed between the n+ region (130) and the p+ region (!40) on the semiconductor substrate,
the trench (180) penetrates at least one of the n+ region and the p+ region, and
the trench (180) is formed by cutting a portion of the semiconductor substrate.

5. The solar cell of any preceding claim, wherein the trench (180) has a depth of 500 nanometers to 50 micrometersand optionally wherein the trench (180) has a width of 10 nanometers to 10 micrometers.

6. The solar cell of any preceding claim, further comprising a dielectric layer (170) disposed on the n+ region (130) on the semiconductor substrate, wherein the dielectric layer (170) is disposed on a portion of the semiconductor substrate where the first electrode (150), the second electrode (160) and the trench (180) are not disposedand optionally wherein the dielectric layer (170) has a thickness of 10 nanometers to 500 nanometers.

7. The solar cell of any preceding claim, further comprising a passivation layer (190) disposed on the semiconductor substrate(110), wherein the passivation layer is disposed on a portion of the semiconductor substrate where the first electrode (150) and the second electrode (160) are not disposed and optionally wherein the passivation layer (190) has a thickness of 10 nanometers to 500 nanometers.

8. A method of manufacturing a solar cell, the method comprising:
providing a semiconductor substrate (110);
disposing an n+ layer (130) on the semiconductor substrate to form an n+ region on the semiconductor substrate;
removing a portion of the n+ layer (130);
forming a trench (180) in the semiconductor substrate;
disposing a first electrode (150) on the semiconductor substrate; and
disposing a second electrode (160) on the semiconductor substrate,
wherein the first electrode (150) and the second electrode (160) are separated by the trench.

9. The method of claim 8, further comprising forming a plurality of n+ regions (130) during the forming the trench.

10. The method of claim 8 or 9, wherein the forming the trench (180) comprises using a laserand optionally wherein the forming the trench further comprises removing a portion of at least one of the semiconductor substrate (110), the n+ layer (130) and a dielectric layer (170), which is damaged by the laser.

11. The method of claim 8, 9 or 10, further comprising disposing a plurality of first electrodes (150) and a plurality of second electrodes, wherein the first electrodes and the second electrodes are alternately disposed on the semiconductor substrate.

12. The method of any of claims 8 to 11, further comprising disposing a dielectric layer (170) on the n+ layer after the disposing the n+ layer.

13. The method of any of claims 8 to 12, further comprising disposing a passivation layer (190) on the semiconductor substrate after the forming the trench (180).

14. The method of any of claims 8 to 13, further comprising converting a portion of the n+ layer (130), corresponding to the second electrode, into a p+ region (140) after the forming the trench (180).

15. The method of any of claims 8 to 14, wherein at least one of the steps of disposing the first electrode (150) and disposing the second electrode (160) comprises using a paste composition.
